# EUROPÄISCHE PATENTANMELDUNG

(11) **EP 3 208 842 A1**
(43) Veröffentlichungstag der Anmeldung: **23.08.2017**
(21) Anmeldenummer: 16156489.3
(22) Anmeldetag: 19.02.2016
(51) Int. Cl.: H01L 23/373, B23K 20/02, B32B 15/01, H01L 21/48

(54) **VERFAHREN ZUR HERSTELLUNG EINER SUBSTRATPLATTE, SUBSTRATPLATTE, VERFAHREN ZUR HERSTELLUNG EINES HALBLEITERMODULS UND HALBLEITERMODUL**

(71) Anmelder: Heraeus Deutschland GmbH & Co. KG, 63450 Hanau (DE)
(72) Erfinder: Eisele, Ronald, 24229 Surendorf (DE)
(74) Vertreter: Meissner Bolte Partnerschaft mbB

(57) **Zusammenfassung**

Die Erfindung betrifft ein Verfahren zur Herstellung einer Substratplatte (10) für ein großflächiges Halbleiterelement (90), insbesondere für eine Thyristorscheibe oder eine Diode, wobei
- mindestens eine erste Schicht (20) aus einem ersten Material (M1) mit einem ersten Ausdehnungskoeffizient und
- mindestens eine zweite Schicht (30) aus einem zweiten, dehnungsarmen Material (M2) mit einem zweiten Ausdehnungskoeffizient, der kleiner als der erste Ausdehnungskoeffizient ist,
bei einer Verbindungstemperatur von 150 °C - 300 °C, insbesondere durch ein Niedertemperatursinterverfahren, miteinander verbunden werden, wobei zwischen der ersten Schicht (20) und der zweiten Schicht (30) mindestens eine erste Verbindungsschicht (40) aus einem Verbindungsmaterial (VM) ausgebildet ist und die Verbindungstemperatur im Wesentlichen der Montagetemperatur bei der Verbindung der hergestellten Substratplatte (10) mit mindestens einem großflächigen Halbleiterelement (90) entspricht.

## Beschreibung

Die Erfindung betrifft ein Verfahren zur Herstellung einer Substratplatte für ein großflächiges Halbleiterelement, insbesondere für eine Thyristorscheibe oder eine Diode. Des Weiteren betrifft die Erfindung eine Substratplatte für ein großflächiges Halbleiterelement, insbesondere für eine Thyristorscheibe oder eine Diode. Außerdem betrifft die Erfindung ein Verfahren zur Herstellung eines Halbleitermoduls sowie ein Halbleitermodul.

Vertikale leistungselektronische Halbleiterelemente, wie Thyristoren oder Dioden sind vorzugsweise einzeln auf thermisch dehnungsarmen Schaltungsträgern, die sowohl elektrisch als auch thermisch hoch leitfähig sein müssen, aufgebracht. Zusätzlich müssen die thermischen Dehnungen des Halbleiterelements, das bei Silizium beispielsweise 2,5 bis 3 ppm/K beträgt, und der leitfähigen Schaltungsträger angepasst werden. Hierzu wird die Differenz zwischen dem thermischen Ausdehnungskoeffizient des Halbleiterelements und dem thermischen Ausdehnungskoeffizient des Schaltungsträgers so klein wie möglich gehalten, um die mechanischen Spannungen zwischen dem Halbleiterelement und dem Schaltungsträger so gering wie möglich zu halten.

Es ist bekannt, sogenannte Substratplatten aus Molybdän für Halbleiterelemente zu verwenden. Molybdän weist einerseits eine relativ geringe thermische Dehnung und andererseits eine gute Wärmeleitfähigkeit auf. Allerdings weist Molybdän einen circa dreifach höheren spezifischen elektrischen Widerstand als Kupfer auf. Außerdem handelt es sich bei Molybdän um ein relativ teures Material.

Es existieren beispielsweise Kupfer-Wolfram-Legierungen (CuW), Kupfer-Molybdän-Legierungen (CuMo) und Cu-Mo-Cu-Plattierungen. Daraus resultieren thermische Dehnungen zwischen 8 ppm/K und 12 ppm/K.

CuW- und CuMo-Legierungen sowie Cu-Mo-Cu-Plattierungen sind technologisch aufwendig herzustellen und äußerst teuer. Insbesondere die Legierungsbildung erfordert aufgrund des hohen Schmelzpunktunterschiedes zwischen Kupfer und den Legierungsbestandteilen Wolfram und Molybdän äußerst umfangreiche Verfahrensschritte bis zur erfolgreichen Legierung. Außerdem wird die Wärmeleitfähigkeit des reinen Kupfers durch die Legierungsbildung stark reduziert.

Die Plattierung von Kupfer und Molybdän muss zur Förderung der bindungsbildenden Diffusion bei sehr hohen Temperaturen, beispielsweise bei Temperaturen von 600 °C bis 800 °C, durchgeführt werden. Während dieses Hochtemperaturprozesses muss durch kostenintensive Maßnahmen die zerstörerische Oxidation des Kupfer-Materials verhindert werden.

Ein weiterer Nachteil der diffusionsgeglühten Schichtenfolge ist die starke Verformung und Verspannung nach Abkühlen von der Diffusionstemperatur auf die Raumtemperatur bzw. Betriebstemperatur des Halbleiterelements, das mit der Substratplatte verbunden ist. Um plane Substratplatten herzustellen, müssen diese in Walzenstöcken streckgewalzt werden. Hierdurch wird teilweise die Diffusionsschicht mechanisch zerstört. Eine asymmetrisch geschichtete Folge von Kupferlagen und Molybdänlagen ist aus diesem Grund durch Diffusionsglühen nicht realisierbar.

Ausgehend von diesem Stand der Technik ist es Aufgabe der vorliegenden Erfindung, ein Verfahren zur Herstellung einer Substratplatte für ein großflächiges Halbleiterelement, insbesondere für eine Thyristorscheibe oder eine Diode, anzugeben, das äußerst einfach und kostengünstig durchzuführen ist und mit dessen Hilfe eine optimierte Substratplatte herstellbar ist.

Des Weiteren ist es Aufgabe der vorliegenden Erfindung, eine Substratplatte für ein großflächiges Halbleiterelement anzugeben, das äußerst dehnungsarm und gleichzeitig kostengünstig ist.

Des Weiteren ist es eine Aufgabe der vorliegenden Erfindung, ein Verfahren zur Herstellung eines Halbleitermoduls anzugeben. Ferner ist es Aufgabe der vorliegenden Erfindung ein weiterentwickeltes Halbleitermodul anzugeben, wobei das Halbleitermodul äußerst dehnungsarm ist und elektrisch hoch leitfähig ausgebildet ist.

Erfindungsgemäß wird die Aufgabe mit Blick auf das Verfahren zur Herstellung einer Substratplatte für ein großflächiges Halbleiterelement durch den Gegenstand des Anspruches 1, mit Blick auf die Substratplatte für ein großflächiges Halbleiterelement durch den Gegenstand des Anspruches 6, mit Blick auf das Verfahren zur Herstellung eines Halbleitermoduls, umfassend eine Substratplatte und mindestens ein großflächiges Halbleiterelement, durch den Gegenstand des Anspruches 16 und mit Blick auf das Halbleitermodul, umfassend eine Substratplatte und mindestens ein großflächiges Halbleiterelement durch den Gegenstand des Anspruches 19 gelöst.

Die Erfindung beruht auf dem Gedanken, ein Verfahren zur Herstellung einer Substratplatte für ein großflächiges Halbleiterelement anzugeben, wobei mindestens eine erste Schicht aus einem ersten Material mit einem ersten Ausdehnungskoeffizient und mindestens eine zweite Schicht aus einem zweiten, dehnungsarmen Material mit einem zweiten Ausdehnungskoeffizient, der kleiner als der erste Ausdehnungskoeffizient ist, bei einer Verbindungstemperatur von 150 °C bis 300 °C miteinander verbunden werden. Besonders bevorzugt erfolgt das Verbinden der ersten Schicht aus einem ersten Material mit der zweiten Schicht aus einem zweiten Material durch ein Niedertemperatursinterverfahren.

Erfindungsgemäß ist außerdem zwischen der ersten Schicht und der zweiten Schicht mindestens eine erste Verbindungsschicht aus einem Verbindungsmaterial ausgebildet.

Die Verbindungstemperatur entspricht im Wesentlichen der Montagetemperatur bei der Verbindung der hergestellten Substratplatte mit mindestens einem großflächigen Halbleiterelement. Bei dem großflächigen Halbleiterelement kann es sich um eine Thyristorscheibe oder eine Diode handeln. Besonders bevorzugt handelt es sich bei dem großflächigen Halbleiterelement um eine Silizium-Halbleiterscheibe.

Die Verbindungstemperatur kann in einer Ausführungsform des erfindungsgemäßen Verfahrens 200 °C bis 280 °C, insbesondere 220 °C bis 270 °C, insbesondere 240 °C bis 260 °C, insbesondere 250 °C, betragen.

Das Verbindungsmaterial der Verbindungsschicht kann vorzugsweise eine Verbindung herstellen, die Temperaturen oberhalb der Verbindungstemperatur standhält. Vorzugsweise weist das Verbindungsmaterial ein Diffusionsmetall, insbesondere Silber (Ag) und/oder eine Silberlegierung und/oder Gold (Au) und/oder eine Goldlegierung und/oder Kupfer (Cu) und/oder eine Kupferlegierung, auf.

Das zweite, dehnungsarme Material mit dem zweiten Ausdehnungskoeffizient der mindestens zweiten Schicht weist vorzugsweise eine Nickellegierung, insbesondere Invar (Fe₆₅Ni₃₅) oder Invar 36 (Fe₆₄Ni₃₆) oder Kovar (Fe₅₄Ni₂₉Co₁₇), und/oder Wolfram (W) und/oder eine Eisen-Nickel-Kobalt-Legierung (FeNiCo-Legierung), auf. Als besonders bevorzugtes Material hinsichtlich des zweiten Materials der mindestens zweiten Schicht hat sich Molybdän (Mo) bzw. eine Molybdänlegierung erwiesen.

Prinzipiell können als zweite Materialien alle Metalle verwendet werden, die einen geringeren Ausdehnungskoeffizient als das Metall des ersten Materials aufweisen. Sofern das erste Material Kupfer oder eine Kupferlegierung ist bzw. die erste Schicht aus Kupfer oder einer Kupferlegierung besteht, sind alle Metalle als zweites Material geeignet, die einen geringeren Ausdehnungskoeffizient als Kupfer aufweisen.

Je niedriger der Ausdehnungskoeffizient des zweiten Materials ist und je höher gleichzeitig die Wärmeleitfähigkeit des zweiten Materials ist, umso besser ist dieser Werkstoff als zweites Material geeignet. Die elektrische Leitfähigkeit ist physikalisch mit der thermischen Leitfähigkeit verbunden. Daher sind alle Metalle, die eine gute thermische und/oder elektrische Leitfähigkeit sowie eine niedrige thermische Dehnung besitzen, gut geeignet, um als zweites Material verwendet zu werden bzw. vom zweiten Material umfasst zu sein.

Folgende Tabelle zeigt in Spalte 6 den Ausdehnungskoeffizient des in der Spalte 1 aufgeführten Werkstoffes. Alle Werkstoffe, die demnach einen kleineren Ausdehnungskoeffizient als Kupfer aufweisen, sind folglich geeignet, als zweites Material zu dienen bzw. als zweites Material verwendet zu werden.

| | | | | | | | | |
|---|---|---|---|---|---|---|---|---|
| 1) Werkstoff (bzw. Kurzzeichen) | | | | 6) Ausdehnungskoeffizient linear (10⁺⁶*alfa) | | | | |
| 2) Dichte | | | | 7) Spez. Wärme | | | | |
| 3) Elastizitätsmodul | | | | 8) Elektrische Leitfähigkeit | | | | |
| 4) Schmelztemperatur | | | | 9) Temperaturkoeffizient des elektrischen Widerstands (10⁺³*alfa) | | | | |
| 5) Wärmeleitfähigkeit | | | | | | | | |

| 1) Werkstoff | 2) Dichte | 3) E. M. | 4) Temp. | 5) WLF | 6) Ausd.k. | 7) sp.W. | 8) E1.Leitf. | 9) Temp.K. |
|---|---|---|---|---|---|---|---|---|
| | kg/ dm³ | kp/ mm² | Grd Celsius | cal/ cmsecgrd | m/ mgrd | cal/ grgrd | m/ Ohmmm² | 1/ grd |
| Silber | 10,49 | 8160 | 960 | 1,00 | 19,7 | 0,056 | 63 | 4,10 |
| Kupfer | 8,96 | 12500 | 1083 | 0,94 | 16,2 | 0,092 | 60 | 4,31 |
| Eisen | 7,87 | 21550 | 1530 | 0,18 | 11,7 | 0,11 | 10,3 | 6,57 |
| Grauguß | 7,20 | 8000-13000 | 1150-1300 | 0,13 | 9,0 | 0,13 | 1-2 | |
| Molybdän | 10,2 | 33630 | 2625 | 0,35 | 5 | 0,061 | 19,4 | 4,73 |
| Monelmetall | 8,58 | 15900 | 1320-1350 | 0,06 | 14 | 0,12 | 1,6 | 0,19 |
| Nickel | 8,90 | 19700 | 1455 | 0,22 | 13,3 | 0,105 | 14,6 | 6,75 |
| Niob | 8,57 | 16000 | 2415 | | 7,0 | 0,0065 | 7,7 | |
| Osmium | 22,5 | 57000 | 2700 | | 4,6 | 0,031 | 10,4 | 4,45 |
| Platin | 21,45 | 17320 | 1774 | 0,17 | 8,9 | 0,032 | 10,2 | 3,92 |
| Stahl C 15 | 7,85 | 20800 | 1510 | 0,12 | 11,1 | 0,11 | 9,3 | 5,7 |
| Stahl C 35 | 7,84 | 20600 | 1490 | 0,12 | 11,1 | 0,11 | 8,6 | 5,2 |
| Stahl C 60 | 7,83 | 20400 | 1470 | 0,11 | 11,1 | 0,11 | 7,9 | 4,7 |
| 41 Cr4 | 7,84 | 20700 | 1490 | 0,1 | 11,0 | 0,11 | 8,0 | |
| X10Cr13 | 7,75 | 22000 | 1500 | 0,065 | 10,0 | 0,11 | 1,7 | |
| 36% Ni-Stahl | 8,13 | 14500 | 1450 | 0,025 | 0,9 | 0,123 | | |
| Tantal | 16,6 | 18820 | 3000 | 0,13 | 6,6 | 0,036 | 8,1 | 3,47 |
| Titan | 4,54 | 10520 | 1800 | 0,041 | 10,8 | 0,126 | 1,25 | 5,46 |
| Vanadium | 6,0 | 15000 | 1735 | | 8,5 | 0,12 | 3,84 | |
| Wismut | 9,8 | 3480 | 271 | 0,020 | 12,4 | 0,034 | 0,94 | 4,45 |
| Wolfram | 19,3 | 41530 | 3380 | 0,48 | 4,5 | 0,032 | 18,2 | 4,82 |
| Zirkon | 6,5 | 6970 | 1850 | | 10 | 0,066 | 2,44 | 4,4 |

Das Verbinden der mindestens ersten Schicht mit der mindestens zweiten Schicht und der Verbindungsschicht kann mittels Druckbeaufschlagung, insbesondere mit einem Druck von 5 MPa - 30 MPa, insbesondere von 10 MPa - 28 MPa, insbesondere von 25 MPa, erfolgen.

Eine vorzugsweise durchzuführende Niedertemperatursinterung zur Verbindung der mindestens ersten und mindestens zweiten Schicht und der mindestens einen Verbindungsschicht erfolgt vorzugsweise bei Temperaturen von 150 °C - 300 °C und bei einem beaufschlagten Druck von 5 MPa - 30 MPa. Besonders bevorzugt wird die Niedertemperatursinterung bei einer Temperatur von 250 °C und einem Druck von 25 MPa durchgeführt, wobei die Sinterung vorzugsweise 1 bis 10 min, beispielsweise 4 min, lang durchgeführt wird.

Die Verbindungstemperatur beim Verfahren zur Herstellung einer Substratplatte entspricht im Wesentlichen der Montagetemperatur bei der Verbindung der hergestellten Substratplatte mit mindestens einem großflächigen Halbleiterelement. Die Verbindungstemperatur kann exakt der Montagetemperatur entsprechen. Des Weiteren ist es möglich, dass die Verbindungstemperatur höchstens 20 %, insbesondere höchstens 15 %, insbesondere höchstens 10 %, insbesondere höchstens 5 %, von der Montagetemperatur abweicht. Die prozentuale Berechnung der Abweichung der Verbindungstemperatur von der Montagetemperatur erfolgt aufgrund einer Berechnung der Differenz zwischen der Verbindungstemperatur in Kelvin und der Montagetemperatur in Kelvin.

Neben dem Durchführen eines Niedertemperatursinterverfahrens ist es außerdem möglich, die einzelnen Schichten der Substratplatte durch Diffusionslöten mit der Ausbildung hochschmelzender intermetallischer Phasen miteinander zu verbinden. Auch die Verwendung von Klebstoffen zur Verbindung der einzelnen Schichten der Substratplatte ist möglich.

Vorzugsweise wird das Verbindungsmaterial als Sintermaterial bzw. Bestandteil des Sintermaterials zwischen die mindestens erste Schicht und die mindestens zweite Schicht eingebracht. Eine zu einer leitfähigen Schicht sinterfähige Zusammensetzung kann demnach zur Herstellung einer Sinterverbindung zwischen den zu verbindenden Schichten verwendet werden. Die noch sinterfähige Zusammensetzung kann die Anwendungsform einer Tinte, einer Paste oder einer Sintervorform in Form eines schichtförmigen Presslings besitzen. Sintervorformen bzw. sogenannte Sinter-Preforms entstehen durch Applikation und Trocknung von Metallpasten bzw. Metallsinterpasten. Derartige Sintervorformen sind noch sinterfähig. Alternativ ist es möglich, dass das Verbindungsmaterial als Folie, insbesondere als Metallfolie, ausgebildet ist und diese Folie, insbesondere Metallfolie, zwischen der ersten Schicht und der zweiten Schicht angeordnet wird.

Es ist möglich, dass die Sinterpaste, die das Verbindungsmaterial umfasst bzw. aus dem Verbindungsmaterial besteht, durch Drucken, insbesondere Sieb- oder Schablonendrucken, auf die erste Schicht und/oder die zweite Schicht aufgebracht wird. Optional kann die Sinterpaste bzw. Metallsinterpaste vor dem Durchführen des eigentlichen Sinterverfahrens getrocknet werden. Ohne den flüssigen Zustand zu durchlaufen, verbinden sich die Metallteilchen der Sinterpaste während des Sinterns durch Diffusion unter Ausbildung einer festen, elektrischen Strom- und Wärme-leitenden metallischen Verbindung bzw. Metallverbindung zwischen der mindestens ersten und zweiten Schicht. Besonders bevorzugt wird beim Verbinden der mindestens ersten und mindestens zweiten Schicht eine Sinterpaste verwendet, die Silber und/oder eine Silberlegierung und/oder Silberkarbonat und/oder Silberoxid umfasst.

In einer weiteren Ausführungsform der Erfindung ist es möglich, dass auf die erste und/oder zweite Schicht, vorzugsweise auf die zweite Schicht, vor dem Aufbringen einer Verbindungsschicht eine, beispielsweise durch Galvanik oder Sputtern aufgebrachte, Schicht zur besseren Anbindung der Verbindungsschicht bzw. Fügeschicht aufgetragen wird. Sofern es sich bei der zweiten Schicht um eine Molybdän-Schicht handelt bzw. das zweite Material der zweiten Schicht Molybdän umfasst, kann auf die zu verbindende Seite der zweiten Schicht eine Nickel-Silber-Schicht (NiAg-Schicht) galvanisch aufgebracht werden. Auf dieser Nickel-Silber-Schicht kann das Verbindungsmaterial, insbesondere Silber, besonders gut haften.

Die Erfindung beruht in einem nebengeordneten Aspekt des Weiteren auf dem Gedanken, eine Substratplatte für ein großflächiges Halbleiterelement, insbesondere für eine Thyristorscheibe oder eine Diode, anzugeben, wobei die Substratplatte vorzugsweise mit einem vorerwähnten erfindungsgemäßen Verfahren hergestellt ist.

Die erfindungsgemäße Substratplatte umfasst:
- mindestens eine erste Schicht aus einem ersten Material mit einem ersten Ausdehnungskoeffizient, und
- mindestens eine zweite Schicht aus einem zweiten, dehnungsarmen Material mit einem zweiten Ausdehnungskoeffizient, der kleiner als der erste Ausdehnungskoeffizient ist,
- wobei zwischen der ersten Schicht und der zweiten Schicht mindestens eine erste Verbindungsschicht, die Diffusionsmetall, insbesondere Silber (Ag) und/oder eine Silberlegierung und/oder Gold (Au) und/oder eine Goldlegierung und/oder Kupfer (Cu) und/oder eine Kupferlegierung, umfasst, ausgebildet ist.

Das erste Material weist vorzugsweise Metall auf oder besteht aus Metall. Insbesondere weist das erste Material Kupfer oder eine Kupferlegierung auf oder das erste Material ist Kupfer oder eine Kupferlegierung. Das zweite Material kann eine Nickellegierung, insbesondere Invar (Fe₆₅Ni₃₅) oder Invar 36 (Fe₆₄Ni₃₆) oder Kovar (Fe₅₄Ni₂₉Co₁₇), und/oder Wolfram (W) und/oder eine Eisen-Nickel-Kobalt-Legierung (FeNiCo-Legierung), aufweisen. Vorzugsweise ist das zweite Material eine Nickellegierung, insbesondere Invar (Fe₆₅Ni₃₅) oder Invar 36 (Fe₆₄Ni₃₆) oder Kovar (Fe₅₄Ni₂₉Co₁₇), und/oder Wolfram (W) und/oder eine Eisen-Nickel-Kobalt-Legierung (FeNiCo-Legierung).

In einer besonders bevorzugten Ausführungsform der Erfindung umfasst das zweite Material Molybdän (Mo) oder das zweite Material ist Molybdän (Mo). Es ist auch denkbar, dass das zweite Material eine Molybdänlegierung umfasst oder eine Molybdänlegierung ist.

Die mindestens erste Verbindungsschicht kann als Grenzschicht der ersten Schicht und/oder der zweiten Schicht ausgebildet sein.

Es ist möglich, dass die Verbindungsschicht eine selbstständige sichtbare Schicht ist. Sofern das Verbindungsmaterial beim Herstellen der erfindungsgemäßen Substratplatte lediglich mit einer geringen Schichtdicke aufgetragen ist, kann die Verbindungsschicht im hergestellten Produkt, nämlich in der hergestellten Substratplatte, als Grenzschicht der ersten Schicht und/oder der zweiten Schicht ausgebildet sein. Das Verbindungsmaterial kann beispielsweise in die erste Schicht und/oder die zweite Schicht zumindest abschnittsweise eindiffundiert sein.

Besonders bevorzugt handelt es sich bei dem Verbindungsmaterial der Verbindungsschicht um Silber oder um eine Silberlegierung, so dass das Silber bzw. die Silberlegierung bei Ausbildung der Verbindungsschicht als Grenzschicht in die erste Schicht und/oder die zweite Schicht abschnittsweise eindiffundiert ist.

In einer weiteren Ausführungsform der Erfindung weist die Substratplatte mindestens eine dritte Schicht auf, wobei die dritte Schicht aus einem/dem ersten Material besteht. Die dritte Schicht ist vorzugsweise mittels einer zweiten Verbindungsschicht aus einem/dem Verbindungsmaterial mit der zweiten Schicht aus dem zweiten, dehnungsarmen Material verbunden. Die Substratplatte kann demnach drei Schichten umfassen, die mit Hilfe von zwei Verbindungsschichten miteinander verbunden sind.

In einer weiteren Ausführungsform der Erfindung kann die Substratplatte mindestens eine vierte Schicht aufweisen, die aus einem/dem zweiten Material gebildet ist. Die vierte Schicht ist vorzugsweise mittels einer dritten Verbindungsschicht aus einem/dem Verbindungsmaterial mit der dritten Schicht aus einem/dem ersten Material verbunden. In dieser Ausführungsform der Erfindung umfasst die Substratplatte vier Schichten, die entweder aus dem ersten Material oder aus dem zweiten Material gebildet sind, wobei diese vier Schichten durch mindestens drei Verbindungsschichten miteinander verbunden sind.

Die Substratplatte kann eine symmetrische Anordnung der einzelnen Schichten und Verbindungsschicht(en) aufweisen. Vorzugsweise ist die symmetrische Anordnung der einzelnen Schichten und Verbindungsschicht(en) derart ausgebildet, dass eine plane Substratplatte gebildet ist. Eine symmetrische Anordnung der einzelnen Schichten ist derart zu verstehen, dass bei einem theoretischen Ausbilden einer Symmetrieachse durch die Substratplatte, sowohl oberhalb als auch unterhalb der Symmetrieachse eine symmetrische Anordnung der einzelnen Schichten und Verbindungsschicht(en) mit übereinstimmenden Materialien und Schichtdicken ausgebildet ist. Die Symmetrieachse halbiert die Anordnung der einzelnen Schichten bezüglich der Gesamtdicke der Substratplatte, wobei die Gesamtdicke der Substratplatte durch die Addierung der einzelnen Schichtdicken gebildet wird.

Bei der Ausbildung einer symmetrischen Anordnung der einzelnen Schichten und Verbindungsschicht(en) ist es möglich, eine plane Substratplatte zu bilden.

In einer alternativen Ausführungsform der Erfindung ist es möglich, dass die einzelnen Schichten und Verbindungsschicht(en) der Substratplatte asymmetrisch angeordnet sind. Die einzelnen Schichten und Verbindungsschicht(en) sind insbesondere derart asymmetrisch angeordnet, dass zunächst eine konvex oder konkav geformte Substratplatte gebildet ist. Vorzugsweise weist die Substratplatte eine gesteuerte konvexe oder konkave Form auf. Mit anderen Worten ist das Balligkeits-Maximum definiert.

Eine asymmetrische Anordnung ist durch eine theoretisch gebildete Symmetrieachse sichtbar. Die Symmetrieachse halbiert die Gesamtdicke der Anordnung der einzelnen Schichten, wobei die Gesamtdicke durch die Addierung der einzelnen Schichtdicken der Substratplatte definiert ist. Vorzugsweise wird die Balligkeit bzw. die konvexe oder konkave Form der Substratplatte durch Anordnung und/oder Ausbildung der zweiten Schicht und/oder der vierten Schicht aus einem/dem zweiten Material, nämlich einem/dem dehnungsarmen Material, gesteuert. Vorzugsweise wird bzw. werden die zweite Schicht und/oder die mindestens vierte Schicht in Relation zur Gesamtanordnung aller Schichten und Verbindungsschicht(en) asymmetrisch ausgebildet, so dass sich gezielt eine Symmetrieachse aus der Dehnung der hergestellten Substratplatte ergibt.

In Abhängigkeit des Anwendungsfalles, kann durch die Position und/oder Ausbildung der zweiten Schicht und/oder der mindestens vierten Schicht aus einem dehnungsarmen zweiten Material nach finaler Abkühlung eine ballige Substratplattenkontur erzielt werden. Hierzu wird die erfindungsgemäße Substratplatte mit Hilfe des vorerwähnten erfindungsgemäßen Verfahrens hergestellt und mit dem noch nacherwähnten erfindungsgemäßen Verfahren zur Herstellung eines Halbleitermoduls mit einem großflächigen Halbleiterelement verbunden.

Um eine asymmetrische Anordnung zu erzielen, können die Schichten der Substratplatte unterschiedliche Schichtdicken aufweisen. Es ist möglich, dass die erste Schicht und die zweite Schicht unterschiedliche Schichtdicken aufweisen. Außerdem ist es möglich, dass die erste Schicht, die zweite Schicht und die dritte Schicht unterschiedliche Schichtdicken aufweisen.

In einer weiteren Ausführungsform der Erfindung kann bzw. können die zweite Schicht und/oder die vierte Schicht in einer Schicht aus dem ersten Material eingebettet sein. Bei der Schicht aus dem ersten Material kann es sich um die erste Schicht und/oder die dritte Schicht handeln.

In einer weiteren Ausführungsform der Erfindung ist bzw. sind die zweite Schicht und/oder die vierte Schicht rahmenartig und/oder gitterartig und/oder drahtartig ausgebildet. Vorzugsweise erfolgt diese Ausbildung der zweiten Schicht und/oder der vierten Schicht in Kombination mit dem Einbetten der jeweiligen Schicht in einer Schicht aus dem ersten Material.

Eine Reduzierung der thermischen Dehnung der Substratplatte wird beispielsweise durch eine erfindungsgemäße Kombination einer Kupferschicht oder Kupferlegierungsschicht mit einer oder mehreren Molybdänschichten erzielt. Ein wachsendes Verhältnis des Molybdän-Anteils zum Kupfer-Anteil der Dicke der Substratplatte, verringert die resultierende Gesamtdehnung. Ein Schichtenverhältnis von 2 Dickenanteilen Kupfer/Kupferlegierung zu 1 Dickenanteil Molybdän/Molybdänlegierung ergibt eine thermische Dehnung von ca. 8 - 9 ppm/K. Das Dickenverhältnis aller Schichten aus dem ersten Material zu allen Schichten aus dem zweiten Material beträgt vorzugsweise 2:1.

Ein geringes E-Modul eines verwendeten Kupfers im Vergleich zum hohen E-Modul des Molybdäns (330 GPa bei 20 °C) führt zu anteilig geringeren Molybdän-Anteilen der Gesamtdicke der Substratplatte. Beispielsweise beträgt das E-Modul des Kupfers einer ersten Schicht und/oder einer mindestens dritten Schicht 60 GPa. Ein derartiges E-Modul wird durch Weichglühen über vier Stunden hinweg unter Beaufschlagung mit Stickstoff (N₂) erzielt.

Die Erfindung beruht des Weiteren auf dem Gedanken, ein Verfahren zur Herstellung eines Halbleitermoduls, das mindestens eine Substratplatte und mindestens ein großflächiges Halbleiterelement umfasst, anzugeben. Vorzugsweise handelt es sich bei der Substratplatte um eine vorerwähnte erfindungsgemäße Substratplatte oder um eine Substratplatte, die mit einem vorerwähnten erfindungsgemäßen Verfahren hergestellt wurde. Bei dem großflächigen Halbleiterelement handelt es sich insbesondere um eine Thyristorscheibe oder eine Diode. Besonders bevorzugt handelt es sich bei dem großflächigen Halbleiterelement um eine Silizium-Halbleiterscheibe.

Das erfindungsgemäße Verfahren zur Herstellung eines Halbleitermoduls beruht darauf, dass das Halbleiterelement mittels einer Kontaktierungsschicht mit der Substratplatte bei einer Montagetemperatur von 150 °C bis 300 °C verbunden wird, wobei die Montagetemperatur im Wesentlichen der Verbindungstemperatur bei der Verbindung von/der Schichten der Substratplatte entspricht. Mit anderen Worten entspricht die Montagetemperatur bei der Verbindung des Halbleiterelements mit der Substratplatte im Wesentlichen der Verbindungstemperatur, die bei der Herstellung der Substratplatte wirkt. Die Montagetemperatur kann exakt der Verbindungstemperatur entsprechen. Vorzugsweise weicht die Montagetemperatur höchstens 20 %, insbesondere höchstens 15 %, insbesondere höchstens 10 %, insbesondere höchstens 5 %, von der Verbindungstemperatur ab. Die prozentuale Berechnung der Abweichung der Montagetemperatur von der Verbindungstemperatur erfolgt aufgrund einer Berechnung der Differenz zwischen der Montagetemperatur in Kelvin und der Verbindungstemperatur in Kelvin.

Die Montagetemperatur kann 200 °C bis 280 °C, insbesondere 220 °C bis 270 °C, insbesondere 240 °C bis 260 °C, insbesondere 250 °C, betragen.

Das großflächige Halbleiterelement wird vorzugsweise auf die Oberfläche der Substratplatte aufgebracht bzw. mit der Oberfläche der Substratplatte verbunden, wobei die Oberfläche von einer Schicht, insbesondere der ersten Schicht oder dritten Schicht, die aus einem ersten Material besteht, gebildet ist. Die Oberfläche kann auch als oberste Seite der Substratplatte bezeichnet werden.

Bei der Kontaktierungsschicht kann es sich beispielsweise um eine Sinterpaste handeln. Es ist auch möglich, dass es sich bei der Kontaktierungsschicht um eine Klebeschicht oder um eine Lotschicht handelt.

In einer Ausführungsform der Erfindung können die Verbindung der Schichten der Substratplatte und die Verbindung der Substratplatte mit dem großflächigen Halbleiterelement gleichzeitig erfolgen. In dieser Ausführungsform werden alle Schichten, Verbindungsschicht(en) sowie das großflächige Halbleiterelement übereinander angeordnet und beispielsweise mittels eines Niedertemperatursinterverfahrens zur gleichen Zeit miteinander verbunden.

Durch Kombination des erfindungsgemäßen Verfahrens zur Herstellung einer Substratplatte mit dem erfindungsgemäßen Verfahren zur Herstellung eines Halbleitermoduls, ist es möglich, ein planes Halbleitermodul mit asymmetrischer Anordnung der Schichten und Verbindungsschicht(en) der Substratplatte herzustellen. Die einzelnen Schicht und Verbindungsschicht(en) der Substratplatte werden asymmetrisch zueinander angeordnet. Die Asymmetrie kann durch die Anzahl der Schichten und/oder durch die Schichtdicken gesteuert werden.

Zum Beispiel ist es möglich, eine Substratplatte aus einer Kupferschicht und einer Molybdänschicht herzustellen. Hierbei können die beiden Schichten unterschiedliche Schichtdicken aufweisen. Außerdem ist eine Cu-Mo-Mo-Cu-Cu-Schichtenfolge denkbar. Hier liegt folglich eine asymmetrische Schichtenanzahl sowie eine asymmetrische Schichtenfolge vor.

Die asymmetrische Anordnung von Schichten und Verbindungsschicht(en) wird bei einer Verbindungstemperatur miteinander verbunden, die im Wesentlichen der Montagetemperatur der Substratplatte mit dem großflächigen Halbleiterelement entspricht.

Die asymmetrische Schichtenfolge führt nun zunächst zu einer balligen Verformung der Substratplatte nach Abkühlung. Es folgt die Verbindung des großflächigen Halbleiterelements mit der Substratplatte. Hierbei zeigt sich, dass sich die ballige Verformung bzw. die konkave oder konvexe Verformung bei Wiedererwärmung der hergestellten asymmetrischen Substratplatte zurückbildet. Nach der Verbindung der Substratplatte mit dem großflächigen Halbleiterelement nimmt das hergestellte Halbleitermodul bzw. die Substratplatte in einem neuen Spannungsgleichgewicht in anforderungsgerechter Weise eine temperaturstabile Endgestalt ein.

Die Erfindung beruht gemäß einem nebengeordneten Aspekt des Weiteren auf dem Gedanken, ein Halbleitermodul anzugeben, wobei das Halbleitermodul vorzugsweise mit einem vorerwähnten erfindungsgemäßen Verfahren hergestellt ist. Das Halbleitermodul umfasst eine Substratplatte und mindestens ein großflächiges Halbleiterelement. Bei der Substratplatte handelt es sich um eine erfindungsgemäße Substratplatte oder um eine Substratplatte, die mittels eines vorerwähnten erfindungsgemäßen Verfahrens hergestellt ist.

Bei dem großflächigen Halbleiterelement handelt es sich insbesondere um eine Thyristorscheibe oder eine Diode. Besonders bevorzugt handelt es sich bei dem großflächigen Halbleiterelement um eine Silizium-Halbleiterscheibe. Das großflächige Halbleiterelement weist vorzugsweise eine Fläche auf, die lediglich geringfügig kleiner als die Grundfläche der Substratplatte ist.

Das Halbleiterelement ist insbesondere mittels einer Kontaktierungsschicht mit der ersten Schicht der Substratplatte verbunden. Bei der Kontaktierungsschicht kann es sich um eine Sinterschicht oder eine elektrisch leitende Klebeschicht oder eine Lotschicht handeln. Bei der ersten Schicht handelt es sich um eine Schicht aus einem ersten Material. Vorzugsweise handelt es sich bei diesem ersten Material um Kupfer oder eine Kupferlegierung.

Die Erfindung wird nachfolgend mit weiteren Einzelheiten unter Bezugnahme auf die beigefügten schematischen Zeichnungen anhand von Ausführungsbeispielen näher erläutert. In diesen zeigen:
- Fig. 1a: die Anordnung einzelner Schichten und Bauteile eines erfindungsgemäßen Halbleitermoduls gemäß erstem Ausführungsbeispiel;
- Fig. 1b: das Halbleitermodul gemäß Fig. 1a im verbundenen Zustand;
- Fig. 2a:: die Anordnung einzelner Schichten und Bauteile eines erfindungsgemäßen Halbleitermoduls gemäß einer zweiten Ausführungsform; und
- Fig. 2b: das Halbleitermodul gemäß Fig. 2a im verbundenen Zustand.

Im Folgenden werden für gleiche und gleichwirkende Teile gleiche Bezugsziffern verwendet.

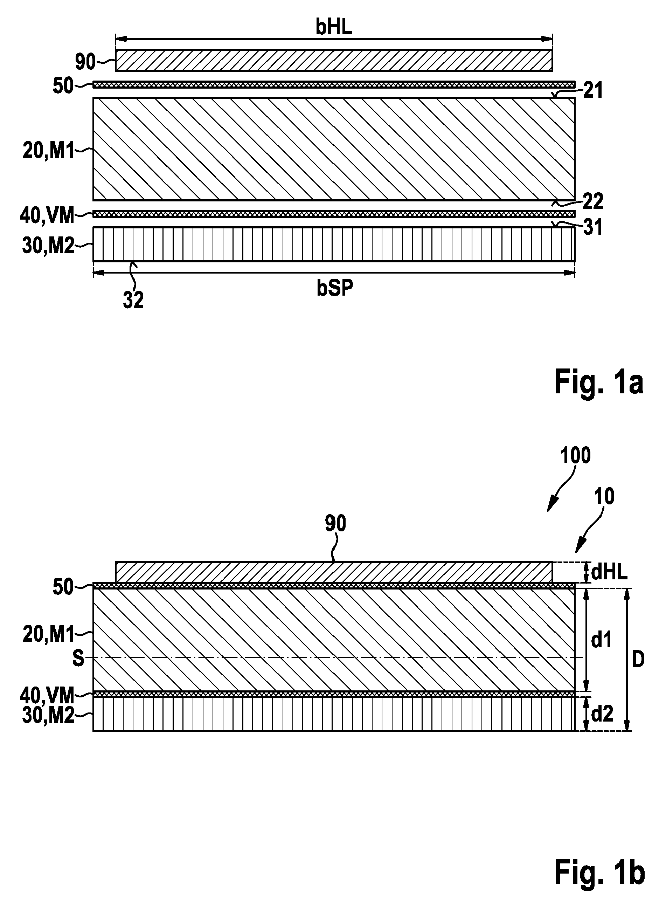

In Fig. 1a sind die einzelnen Schichten und Bauteile eines herzustellenden Halbleitermoduls 100 (siehe Fig. 1b) dargestellt. Das Halbleitermodul 100 besteht aus dem großflächigen Halbleiterelement 90 und der Substratplatte 10. Die Substratplatte 10 umfasst eine erste Schicht 20 aus einem ersten Material M1 und eine zweite Schicht 30 aus einem zweiten Material M2. Bei dem Material M1 handelt es sich vorzugsweise um Metall, insbesondere um Kupfer oder eine Kupferlegierung.

Das Material M2 ist hingegen ein dehnungsarmes Material mit einem zweiten Ausdehnungskoeffizient, der kleiner ist als der erste Ausdehnungskoeffizient des ersten Materials M1. Bei dem zweiten Material M2 kann es sich um eine Nickellegierung, insbesondere Invar oder Invar 36 oder Kovar und/oder Wolfram und/oder eine Eisen-Nickel-Kobalt-Legierung handeln. Im vorliegenden Ausführungsbeispiel handelt es sich bei dem Material M2 um Molybdän. Zwischen der ersten Schicht 20 und der zweiten Schicht 30 ist eine erste Verbindungsschicht 40 aus einem Verbindungsmaterial VM ausgebildet. Das Verbindungsmaterial VM der Verbindungsschicht 40 schafft eine Verbindung zwischen der ersten Schicht 20 und der zweiten Schicht 30, die Temperaturen oberhalb einer Verbindungstemperatur standhält. Vorzugsweise weist die Verbindungsschicht Diffusionsmetall, insbesondere Silber und/oder eine Silberlegierung und/oder Gold und/oder eine Goldlegierung und/oder Kupfer und/oder eine Kupferlegierung, auf.

Vorzugsweise ist die Verbindungsschicht als Sinterschicht, insbesondere als Sinterpaste, ausgebildet. Diese Sinterpaste, die vorzugsweise eines der aufgeführten Diffusionsmetalle, insbesondere Silber und/oder eine Silberlegierung und/oder Silberkarbonat und/oder Silberoxid, aufweist, kann beispielsweise mittels eines Druckverfahrens auf die zweite Seite 22 der ersten Schicht 20 und/oder auf die erste Seite 31 der zweiten Schicht 30 aufgebracht werden. Die erste Seite 21 der ersten Schicht 20 weist im verbundenen Zustand der Substratplatte 10 zum großflächigen Halbleiterelement 90. Die zweite Seite 22 der ersten Schicht 20 weist hingegen zur zweiten Schicht 30. Die erste Seite 31 der zweiten Schicht 30 weist im verbundenen Zustand zur ersten Schicht 20. Die zweite Seite 32 der zweiten Schicht 30 ist hingegen von der ersten Schicht 20 abgewandt ausgebildet. Die Schichtdicke d1 der ersten Schicht 20 ist mindestens doppelt so groß wie die Schichtdicke d2 der zweiten Schicht 30. Vorzugsweise beträgt die Schichtdicke d1 zwischen 0,2 mm und 3,0 mm, wohingegen die Schichtdicke d2 zwischen 0,1 mm und 2,0 mm beträgt. Die Dicke der ersten Verbindungsschicht 40 beträgt beispielsweise zwischen 1 µm und 50 µm.

Mit Hilfe der in Fig. 1b eingezeichneten Symmetrieachse S wird ersichtlich, dass es sich bei dem Aufbau der Substratplatte 10 um einen asymmetrischen Aufbau der einzelnen Schichten 20, 30 und 40 handelt. Die Symmetrieachse S halbiert die Gesamtdicke D der Substratplatte 10. Die Gesamtdicke D wird durch Addition der Schichtdicken d1 und d2 sowie der Schichtdicke der ersten Verbindungsschicht 40 gebildet. Mit Hilfe einer derart asymmetrischen Substratplatte 10 kann insbesondere ein planes Halbleitermodul 100 hergestellt werden.

Bei dem großflächigen Halbleiterelement 90 handelt es sich im dargestellten Beispiel um einen als Thyristor ausgebildeten Silizium-Halbleiter. Die Breite bHL des Halbleiterelements 90 ist nur geringfügig kleiner als die Breite bSP der Substratplatte. Das großflächige Halbleiterelement 90 wird im dargestellten Beispiel mittels einer Kontaktierungsschicht 50 mit der Substratplatte 10 verbunden. Bei der Kontaktierungsschicht 50 kann es sich prinzipiell um eine Klebeschicht, eine Sinterpastenschicht oder um eine Lotschicht handeln. Im vorliegenden Fall werden alle Schichten 20, 30 und 40 mit dem großflächigen Halbleiterelement 90 sowie der Kontaktierungsschicht 50 gleichzeitig verbunden, so dass die Kontaktierungsschicht 50 vorzugsweise äquivalent zur ersten Verbindungsschicht 40 ausgebildet ist. Bei der ersten Verbindungsschicht 40 und der Kontaktierungsschicht 50 handelt es sich vorzugsweise um eine Sinterpaste.

Vorzugsweise werden die Schichten 20, 30, 40, 50 sowie das großflächige Halbleiterelement 90 bei einer Verbindungstemperatur von 150 °C bis 300 °C durch ein Niedertemperatursinterverfahren miteinander verbunden. Besonders bevorzugt beträgt die Verbindungstemperatur 250 °C.

Das Verbinden der Schichten 20, 30, 40, 50 mit dem großflächigen Halbleiterelement 90 erfolgt vorzugsweise mittels Druckbeaufschlagung, insbesondere mit einem Druck von 5 MPa bis 30 MPa, insbesondere von 10 MPa bis 28 MPa, insbesondere von 25 MPa.

Alternativ kann das großflächige Halbleiterelement 90 in einem separaten Montageschritt auf eine vorher hergestellte Substratplatte 10 aufgebracht werden. Hierzu wird mit Hilfe der Kontaktierungsschicht 50 das großflächige Halbleiterelement 90 auf die erste Seite 21 der ersten Schicht 20 der Substratplatte 10 aufgebracht. Bei der mit dem Halbleiterelement zu verbindenden Oberfläche 21 der Substratplatte 10 handelt es sich um die erste Seite 21 der ersten Schicht 20.

Zum Verbinden des großflächigen Halbleiterelements 90 mit einer vorher hergestellten Substratplatte 10 wird die Anordnung mit einer Montagetemperatur von 150 °C bis 300 °C beaufschlagt, wobei diese Montagetemperatur im Wesentlichen der Verbindungstemperatur bei der Verbindung der Schichten 20, 30 und 40 der Substratplatte 10 entspricht.

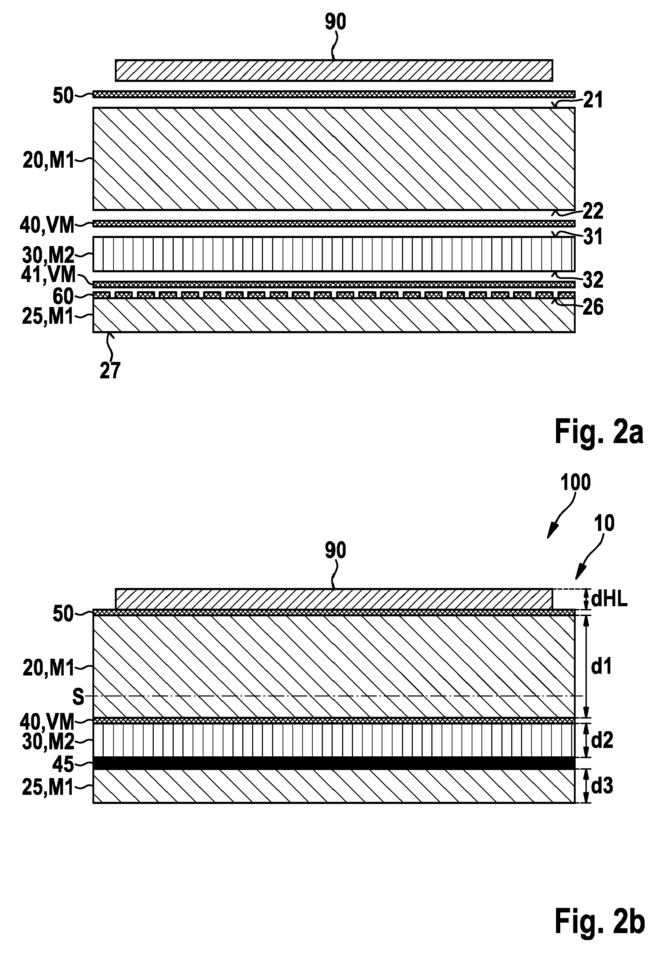

In den Figuren 2a und 2b wird eine zweite Ausführungsform hinsichtlich eines herzustellenden Halbleitermoduls 100 (siehe Fig. 2b) dargestellt. Hierbei handelt es sich ebenfalls um einen asymmetrischen Aufbau der Substratplatte 10.

Die Substratplatte 10 besteht aus einer ersten Schicht 20, einer zweiten Schicht 30 und einer dritten Schicht 25. Die erste Schicht 20 und die dritte Schicht 25 weisen ein erstes Material M1 auf. Bei dem Material handelt es sich vorzugsweise um Kupfer. Zwischen diesen beiden Schichten 20 und 25, die unterschiedliche Schichtdicken d1 und d3 aufweisen, ist eine zweite Schicht 30 aus dem zweiten Material M2 ausgebildet. Das zweite Material M2 besteht aus einem dehnungsärmeren Material bzw. der Ausdehnungskoeffizient des zweiten Materials M2 ist geringer als der Ausdehnungskoeffizient des ersten Materials M1. Vorzugsweise ist das zweite Material M2 Molybdän.

Die angedeutete Symmetrieachse S zeigt, dass es sich auch bei der Substratplatte 10 gemäß Fig. 2a bzw. 2b um einen asymmetrischen Aufbau selbiger handelt. Zwischen der ersten Schicht 20 und der zweiten Schicht 30 ist eine erste Verbindungsschicht 40 ausgebildet. Bei dieser Verbindungsschicht 40 handelt es sich vorzugsweise um eine Sinterschicht, die ein Verbindungsmaterial VM, vorzugsweise Silber, aufweist. Zwischen der zweiten Schicht 30 und der dritten Schicht 25 ist ebenfalls eine zweite Verbindungsschicht 41 ausgebildet. Bei dieser Verbindungsschicht 41 handelt es sich vorzugsweise ebenfalls um eine Sinterschicht, die ein Verbindungsmaterial VM, nämlich Silber, aufweist.

Auf der ersten Seite 26 der dritten Schicht 25 (siehe Fig. 2a) ist vorzugsweise eine haftverbessernde Schicht 60 aufgebracht. Bei der ersten Seite 26 der dritten Schicht 25 handelt es sich um die der zweiten Schicht 30 zugewandte Seite der dritten Schicht 25. Die haftverbessernde Schicht 60 ist vorzugsweise galvanisch auf die dritte Schicht 25 aufgebracht. Bei der haftverbessernden Schicht 60 handelt es sich beispielsweise um eine Silber-Schicht. Mit Hilfe der haftverbessernden Schicht 60 kann die Haftung zwischen der dritten Schicht 25 und der zweiten Verbindungsschicht 41 verbessert werden.

Im zusammengefügten Zustand liegt eine kombinierte Verbindungsschicht 45 (siehe Fig. 2b) vor. Mit Hilfe eines Niedertemperatursinterverfahrens werden die zweite Verbindungsschicht 41 und die haftverbessernde Schicht 60 miteinander verpresst, so dass die kombinierte Verbindungsschicht 45 gebildet wird.

Das großflächige Halbleiterelement 90 wird wiederum mit Hilfe der Kontaktierungsschicht 50 auf die erste Seite 21 der ersten Schicht 20 aufgebracht.

Auch im Zusammenhang mit dem Ausführungsbeispiel gemäß Figuren 2a und 2b ist ersichtlich, dass die Schichtdicke d1 der ersten Schicht 20 um ein vielfaches größer ist als die Schichtdicke d2 der zweiten Schicht 30 aus dehnungsarmen Material M2. Die Schichtdicke d1 der ersten Schicht 20 ist ebenfalls größer als die Schichtdicke d3 der dritten Schicht 25 aus erstem Material M1.

Die zweite Schicht 30 aus dehnungsarmen zweiten Material M2 ist asymmetrisch innerhalb des Schichtenstapels ausgebildet. Eine asymmetrische Platzierung der dehnungsarmen zweiten Schicht 30 hat den Vorteil, dass sich gezielt eine Symmetrieachse aus der Dehnung des großflächigen Halbleiterelements 90, insbesondere des Silizium-Halbleiterelements, und der Dehnung der geschichteten Substratplatte 10 ergibt. In Abhängigkeit von der Dicke dHL des großflächigen Halbleiterelements 90 kann durch die Position der zweiten Schicht 30 aus dehnungsarmen Material M2 final nach der Abkühlung eine planare Kontur des Halbleitermoduls 100 erzielt werden.

### Bezugszeichenliste

- 10: Substratplatte
- 20: erste Schicht
- 21: erste Seite erste Schicht
- 22: zweite Seite erste Schicht
- 25: dritte Schicht
- 26: erste Seite dritte Schicht
- 27: zweite Seite dritte Schicht
- 30: zweite Schicht
- 31: erste Seite zweite Schicht
- 32: zweite Seite zweite Schicht
- 40: erste Verbindungsschicht
- 41: zweite Verbindungsschicht
- 45: kombinierte Verbindungsschicht
- 50: Kontaktierungsschicht
- 60: haftverbessernde Schicht
- 90: großflächiges Halbleiterelement
- 100: Halbleitermodul
- bHL: Breite Halbleiterelement
- bSP: Breite Substratplatte
- d1: Schichtdicke erste Schicht
- d2: Schichtdicke zweite Schicht
- d3: Schichtdicke dritte Schicht
- dHL: Schichtdicke Halbleiterelement
- D: Gesamtdicke Substratplatte
- S: Symmetrieachse
- M1: erstes Material
- M2: zweites Material
- VM: Verbindungsmaterial

## Patentansprüche

1. Verfahren zur Herstellung einer Substratplatte (10) für ein großflächiges Halbleiterelement (90), insbesondere für eine Thyristorscheibe oder eine Diode,
**dadurch gekennzeichnet, dass**
mindestens eine erste Schicht (20) aus einem ersten Material (M1) mit einem ersten Ausdehnungskoeffizient und
mindestens eine zweite Schicht (30) aus einem zweiten, dehnungsarmen Material (M2) mit einem zweiten Ausdehnungskoeffizient, der kleiner als der erste Ausdehnungskoeffizient ist,
bei einer Verbindungstemperatur von 150 °C - 300 °C, insbesondere durch ein Niedertemperatursinterverfahren, miteinander verbunden werden, wobei zwischen der ersten Schicht (20) und der zweiten Schicht (30) mindestens eine erste Verbindungsschicht (40) aus einem Verbindungsmaterial (VM) ausgebildet ist und die Verbindungstemperatur im Wesentlichen der Montagetemperatur bei der Verbindung der hergestellten Substratplatte (10) mit mindestens einem großflächigen Halbleiterelement (90) entspricht.

2. Verfahren nach Anspruch 1,
**dadurch gekennzeichnet, dass**
die Verbindungstemperatur 200 °C - 280 °C, insbesondere 220 °C - 270 °C, insbesondere 240 °C - 260 °C, insbesondere 250 °C, beträgt.

3. Verfahren nach Anspruch 1 oder 2,
**dadurch gekennzeichnet, dass**
das Verbindungsmaterial (VM) der Verbindungsschicht (40, 41) eine Verbindung herstellt, die Temperaturen überhalb der Verbindungstemperatur standhält und vorzugsweise ein Diffusionsmetall, insbesondere Silber (Ag) und/oder eine Silberlegierung und/oder Gold (Au) und/oder eine Goldlegierung und/oder Kupfer (Cu) und/oder eine Kupferlegierung, aufweist.

4. Verfahren nach einem der vorhergehenden Ansprüche,
**dadurch gekennzeichnet, dass**
das erste Material (M1) Metall, insbesondere Kupfer (Cu) oder eine Kupferlegierung, aufweist und/oder das zweite Material (M2) eine Nickellegierung, insbesondere Invar (Fe₆₅Ni₃₅) oder Invar 36 (Fe₆₄Ni₃₆) oder Kovar (Fe₅₄Ni₂₉Co₁₇), und/oder Wolfram (W) und/oder eine Eisen-Nickel-Kobalt-Legierung (FeNiCo-Legierung), besonders bevorzugt Molybdän (Mo), aufweist.

5. Verfahren nach einem der vorhergehenden Ansprüche,
**dadurch gekennzeichnet, dass**
das Verbinden der mindestens ersten Schicht (20) mit der mindestens zweiten Schicht (30) und der mindestens ersten Verbindungsschicht (40) mittels Druckbeaufschlagung, insbesondere mit einem Druck von 5 MPa - 30 MPa, insbesondere von 10 MPa - 28 MPa, insbesondere von 25 MPa, erfolgt.

6. Substratplatte (10) für ein großflächiges Halbleiterelement (90), insbesondere für eine Thyristorscheibe oder eine Diode, insbesondere Substratplatte, hergestellt nach einem Verfahren nach einem der Ansprüche 1 bis 5, umfassend:
- mindestens eine erste Schicht (20) aus einem ersten Material (M1) mit einem ersten Ausdehnungskoeffizient,
- mindestens eine zweite Schicht (30) aus einem zweiten, dehnungsarmen Material (M2) mit einem zweiten Ausdehnungskoeffizient, der kleiner als der erste Ausdehnungskoeffizient ist,
- wobei zwischen der ersten Schicht (20) und der zweiten Schicht (30) mindestens eine erste Verbindungsschicht (40), die vorzugsweise Diffusionsmetall, insbesondere Silber (Ag) und/oder eine Silberlegierung und/oder Gold (Au) und/oder eine Goldlegierung und/oder Kupfer (Cu) und/oder eine Kupferlegierung, umfasst, ausgebildet ist.

7. Substratplatte (10) nach Anspruch 6,
**dadurch gekennzeichnet, dass**
die mindestens erste Verbindungsschicht (40) als Grenzschicht der ersten Schicht (20) und/oder der zweiten Schicht (30) ausgebildet ist.

8. Substratplatte (10) nach Anspruch 6 oder 7,
**dadurch gekennzeichnet, dass**
das erste Material (M1) Metall, insbesondere Kupfer (Cu) oder eine Kupferlegierung, aufweist und/oder das zweite Material (M2) eine Nickellegierung, insbesondere Invar (Fe₆₅Ni₃₅) oder Invar 36 (Fe₆₄Ni₃₆) oder Kovar (Fe₅₄Ni₂₉Co₁₇), und/oder Wolfram (W) und/oder eine Eisen-Nickel-Kobalt-Legierung (FeNiCo-Legierung), besonders bevorzugt Molybdän (Mo), aufweist.

9. Substratplatte (10) nach einem der Ansprüche 6 bis 8,
**gekennzeichnet durch**
mindestens eine dritte Schicht (25) aus einem/dem ersten Material (M1), die mittels einer zweiten Verbindungsschicht (41) aus einem/dem Verbindungsmaterial (VM) mit der zweiten Schicht (30) aus dem zweiten, dehnungsarmen Material (M2) verbunden ist.

10. Substratplatte (10) nach Anspruch 9,
**gekennzeichnet durch**
mindestens eine vierte Schicht aus einem/dem zweiten Material (M2), die mittels einer dritten Verbindungsschicht aus einem/dem Verbindungsmaterial (VM) mit der dritten Schicht (25) aus einem/dem ersten Material (M1) verbunden ist.

11. Substratplatte (10) nach einem der Ansprüche 6 bis 10, insbesondere nach einem der Ansprüche 9 oder 10,
**gekennzeichnet durch**
eine symmetrische Anordnung der einzelnen Schichten (20, 25, 30) und Verbindungsschicht(en) (40, 41), insbesondere derart, dass eine plane Substratplatte (10) gebildet ist.

12. Substratplatte (10) nach einem der Ansprüche 6 bis 10, insbesondere nach einem der Ansprüche 9 oder 10,
**gekennzeichnet durch**
eine asymmetrische Anordnung der einzelnen Schichten (20, 25, 30) und Verbindungsschicht(en) (40, 41), insbesondere derart, dass eine konvex oder konkav geformte Substratplatte (10) gebildet ist.

13. Substratplatte (10) nach einem der Ansprüche 6 bis 12, insbesondere nach einem der Ansprüche 8 bis 12,
**dadurch gekennzeichnet, dass**
die erste Schicht (20) und die zweite Schicht (30), insbesondere die erste Schicht (20) und die zweite Schicht (30) und die dritte Schicht (25), unterschiedliche Schichtdicken (d1, d2, d3) aufweisen.

14. Substratplatte (10) nach einem der Ansprüche 6 bis 13,
**dadurch gekennzeichnet, dass**
die zweite Schicht (20) und/oder die mindestens vierte Schicht in einer Schicht (20, 25) aus dem ersten Material (M1) eingebettet ist.

15. Substratplatte (10) nach einem der Ansprüche 6 bis 14,
**dadurch gekennzeichnet, dass**
die zweite Schicht (30) und/oder die vierte Schicht rahmenartig und/oder gitterartig und/oder drahtartig ausgebildet ist.

16. Verfahren zur Herstellung eines Halbleitermoduls (100),
umfassend eine Substratplatte (10), insbesondere nach einem der Ansprüche 6 bis 15 oder eine Substratplatte, die mittels eines Verfahrens nach einem der Ansprüche 1 bis 5 hergestellt ist,
und mindestens ein großflächiges Halbleiterelement (90), insbesondere eine Thyristorscheibe oder eine Diode,
**dadurch gekennzeichnet, dass**
das großflächige Halbleiterelement (90) mittels einer Kontaktierungsschicht (50) mit der Substratplatte (10) bei einer Montagetemperatur von 150 °C - 300 °C verbunden wird, wobei die Montagetemperatur im Wesentlichen der Verbindungstemperatur bei der Verbindung der Schichten (20, 25, 30, 40, 41) der Substratplatte (10) entspricht.

17. Verfahren nach Anspruch 16,
**dadurch gekennzeichnet, dass**
die Verbindung der Schichten (20, 25, 30, 40, 41) der Substratplatte (10) und die Verbindung des großflächigen Halbleiterelements (90) mit der Substratplatte (10) gleichzeitig erfolgt.

18. Verfahren nach Anspruch 16 oder 17,
**dadurch gekennzeichnet, dass**
die Montagetemperatur 200 °C - 280 °C, insbesondere 220 °C - 270 °C, insbesondere 240 °C - 260 °C, insbesondere 250 °C, beträgt.

19. Halbleitermodul (100), insbesondere hergestellt nach einem der Anprüche 16 bis 18, umfassend
eine Substratplatte (10) nach einem der Ansprüche 6 bis 15 oder eine Substratplatte (10), die mittels eines Verfahrens nach einem der Ansprüche 1 bis 5 hergestellt ist,
und mindestens ein großflächiges Halbleiterelement (90), insbesondere eine Thyristorscheibe oder eine Diode.

20. Halbleitermodul (100) nach Anspruch 19,
**dadurch gekennzeichnet, dass**
das großflächige Halbleiterelement (90), insbesondere mittels einer Kontaktierungsschicht (50), mit der ersten Schicht (20) der Substratplatte (10) verbunden ist.
